# EUROPEAN PATENT APPLICATION

(11) **EP 4 707 995 A2**
(43) Date of publication of application: **11.03.2026**
(21) Application number: 26153177.6
(22) Date of filing: 07.02.2023
(51) Int. Cl.: G06F 1/20

(54) **EXPANSION COMPONENT**

(30) Priority: 11.02.2022 US 202263309463 P; 12.06.2022 US 202263351422 P; 22.11.2022 CN 202211467197
(62) Divisional of application: 23155307.4
(71) Applicant: Getac Technology Corporation, New Taipei City (TW)
(72) Inventor: YANG, Jui-Lin, 11568 Taipei City (TW); HSU, Wan-Lin, 11568 Taipei City (TW); CHOU, Hsin-Chih, 11568 Taipei City (TW); LEE, Kun-Cheng, 11568 Taipei City (TW); CHANG, Juei-Chi, 11568 Taipei City (TW)
(74) Representative: Viering, Jentschura & Partner mbB Patent- und Rechtsanwälte

(57) **Abstract**

An expansion component, comprising: a case (H), comprising a bottom plate (H12), a top plate (H11), and a first side edge (H13), a second side edge (H14), a third side edge (H15), and a fourth side edge (H16) that are sequentially connected, wherein the first side edge (H13), the second side edge (H14), the third side edge (H15), and the fourth side edge (H16) are respectively connected to the bottom plate (H12) and the top plate (H11) to form an accommodating space (S); two openings (H111), running through the top plate (H11) and located on the first side edge (H13), wherein the two openings (H111) are respectively adjacent to the second side edge (H14) and the fourth side edge (H16); a partition (10), arranged in the accommodating space (S) and parallel to the bottom plate (H12), wherein the partition (10) divides the accommodating space (S) into an upper compartment (S11) and a lower compartment (S12); and a plurality of electronic components (A), arranged in the accommodating space (S) and scattered in the upper compartment (S11) and the lower compartment (S12).

## Description

### BACKGROUND OF THE INVENTION

The present invention relates to an expansion component.

With the popularization of electronic products, users have increasingly diversified requirements for the performance of electronic devices. To meet various requirements of the users, a quantity of electronic components in the electronic device is increasing, which also causes problems of space configuration and heat dissipation in the electronic device. How to increase configurations of the electronic components in a limited space of the electronic device to improve efficiency while taking into account a heat dissipation effect is a problem that the inventors are urgently trying to resolve.

### SUMMARY OF THE INVENTION

According to the invention, an expansion component according to claim 1 is provided. Further examples thereof are defined in the dependent claims.

This present invention provides an electronic device assembly, including an expansion component and a host. The expansion component includes a first case, a first circuit board, and at least one first connector. The host includes a second case, a main circuit board, and a main connector. The first case includes a top plate and a bottom plate that are opposite to each other, where a first accommodating space is formed between the top plate and the bottom plate, and the top plate is provided with an opening. The first circuit board is arranged in the first accommodating space. The first connector is electrically connected to the first circuit board, and the first connector is exposed from the top plate at the opening. The second case includes a first surface and a second surface that are opposite to each other, where a second accommodating space is formed between the first surface and the second surface. The main circuit board is arranged in the second accommodating space. The main connector is electrically connected to the main circuit board and exposed from the second surface. When the host is assembled to the expansion component, the second surface of the second case covers the top plate of the first case and the opening, and the first connector is electrically connected to the main connector.

In some embodiments, the opening is located in the middle of the expansion component, and the expansion component further includes a waterproof member that is arranged around the opening.

In some embodiments, the expansion component further includes a partition, where the partition is parallel to the top plate and is arranged in the first accommodating space, and divides the first accommodating space of the expansion component into an upper compartment and a lower compartment.

In some embodiments, the electronic device assembly further includes a second circuit board, batteries, and a second connector, where the first circuit board is arranged in the upper compartment, the second circuit board and the batteries are arranged in the lower compartment and are electrically connected to each other, and the second connector penetrates the partition and is electrically connected to the first circuit board and the second circuit board.

The present invention further provides an expansion component, including a case, two openings, a partition, and a plurality of electronic components. The case includes a bottom plate, a top plate, and a first side edge, a second side edge, a third side edge, and a fourth side edge that are sequentially connected, where the first side edge, the second side edge, the third side edge, and the fourth side edge are respectively connected to the bottom plate and the top plate to form an accommodating space. The openings run through the top plate and are located on the first side edge, where the two openings are respectively adjacent to the second side edge and the fourth side edge. The partition is arranged in the accommodating space and parallel to the bottom plate, and the partition divides the accommodating space into an upper compartment and a lower compartment. The electronic components are arranged in the accommodating space and scattered in the upper compartment and the lower compartment.

In some embodiments, the expansion component further includes two assembly grooves, respectively corresponding to the two openings, where the two assembly grooves are connected to the top plate and are recessed toward the bottom plate.

In some embodiments, the expansion component further includes two fans, respectively assembled in the two assembly grooves.

In some embodiments, two heat dissipation pipe grooves are recessed on a side of the top plate away from the bottom plate, and the two heat dissipation pipe grooves respectively extend from the third side edge to the corresponding openings.

In some embodiments, the electronic components include a first circuit board, a second circuit board, and a connector, where the first circuit board is accommodated in the upper compartment and assembled on a side of the top plate toward the bottom plate, the second circuit board is accommodated in the lower compartment, and the connector penetrates the partition and is electrically connected to the first circuit board and the second circuit board.

In some embodiments, the electronic components further include a plurality of disk arrays, accommodated in the upper compartment and electrically connected to the first circuit board, where the disk arrays are respectively assembled on two sides of the first circuit board and located between one assembly groove and the third side edge.

In some embodiments, two heat dissipation pipes are arranged on a side of the top plate away from the bottom plate, and the two heat dissipation pipes correspond to the disk arrays.

In some embodiments, the expansion component further includes two waterproof cover plates, correspondingly covering the two openings.

In some embodiments, the electronic components include a first circuit board, a bus apparatus, at least one fan, a second circuit board, and a connector, where the first circuit board is accommodated in the upper compartment and assembled on a side of the top plate toward the bottom plate, and the bus apparatus is accommodated in the upper compartment and electrically connected to the first circuit board. The fan is accommodated in the upper compartment and electrically connected to the first circuit board. The second circuit board is accommodated in the lower compartment. The connector penetrates the partition and is electrically connected to the first circuit board and the second circuit board.

In some embodiments, the electronic components further include at least one battery, accommodated in the lower compartment and electrically connected to the second circuit board.

The present invention provides another expansion component, including a case, two openings, a partition, a first circuit board, a second circuit board, at least one battery, and a connector. The case includes a bottom plate, a top plate, and a first side edge, a second side edge, a third side edge, and a fourth side edge that are sequentially connected, where the first side edge, the second side edge, the third side edge, and the fourth side edge are respectively connected to the bottom plate and the top plate to form an accommodating space. The openings run through the top plate and are located on the first side edge, and the two openings are respectively adjacent to the second side edge and the fourth side edge. The partition is arranged in the accommodating space and parallel to the bottom plate, and divides the accommodating space into an upper compartment and a lower compartment. The first circuit board is accommodated in the upper compartment, the second circuit board is accommodated in the lower compartment, the battery is accommodated in the lower compartment and electrically connected to the second circuit board, and the connector penetrates the partition and is electrically connected to the first circuit board and the second circuit board.

In some embodiments, the expansion component further includes two bus apparatuses and two fans, both accommodated in the upper compartment and electrically connected to the first circuit board.

### BRIEF DESCRIPTION OF DRAWINGS

FIG. 1 is a schematic three-dimensional external view of an embodiment of an electronic device assembly according to the present invention;
FIG. 2 is a first schematic three-dimensional exploded diagram of an embodiment of an electronic device assembly according to the present invention;
FIG. 3 is a second schematic three-dimensional exploded diagram of an embodiment of an electronic device assembly according to the present invention;
FIG. 4 is a schematic cross-sectional view drawn along a division line 4-4 in FIG. 1;
FIG. 5 is a schematic three-dimensional external view of an embodiment of an expansion component in an electronic device assembly according to the present invention;
FIG. 6 is a schematic cross-sectional view drawn along a division line 6-6 in FIG. 2;
FIG. 7 is a schematic cross-sectional view drawn along a division line 7-7 in FIG. 3;
FIG. 8 is a schematic diagram of a partial structure of an embodiment of an expansion component according to the present invention;
FIG. 9 is a first schematic exploded view of a partial structure of another embodiment of an expansion component according to the present invention;
FIG. 10 is a second schematic exploded view of a partial structure of another embodiment of an expansion component according to the present invention;
FIG. 11 is a schematic cross-sectional view drawn along a division line 11-11 in FIG. 2;
FIG. 12 is a schematic partial enlarged view of a circle 12 in FIG. 11;
FIG. 13 is a schematic three-dimensional external view of an embodiment of a heat dissipation module in an expansion component according to the present invention; and
FIG. 14 is a schematic cross-sectional view drawn along a division line 14-14 in FIG. 13.

### DETAILED DESCRIPTION OF THE INVENTION

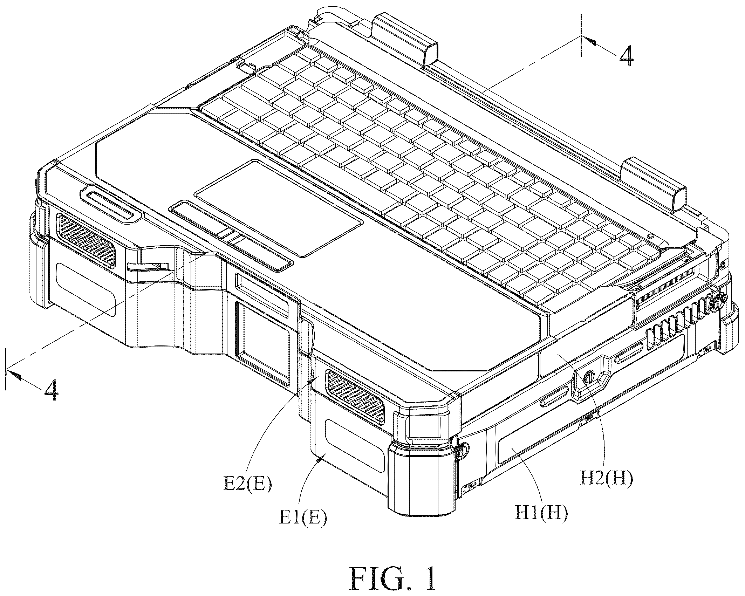

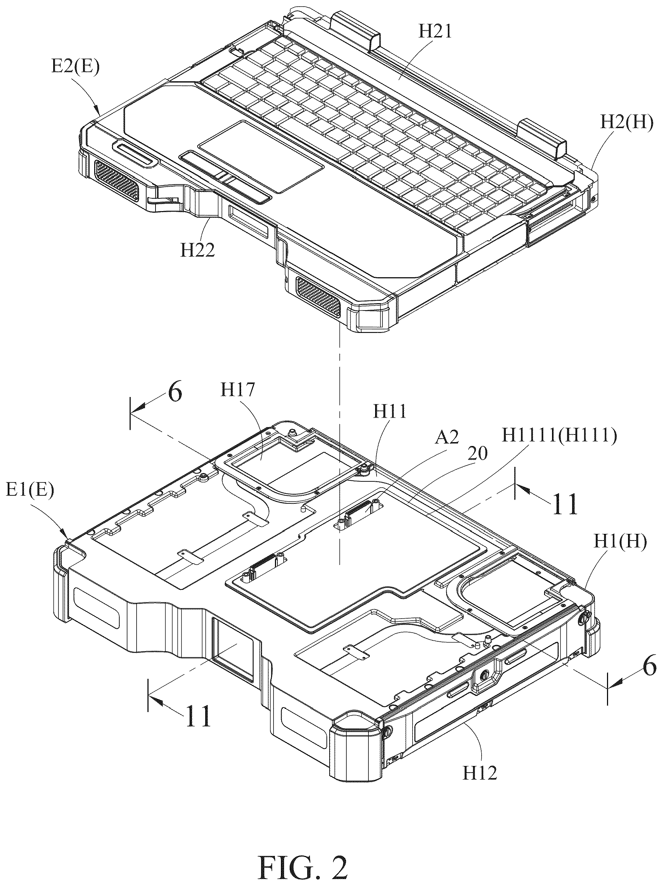

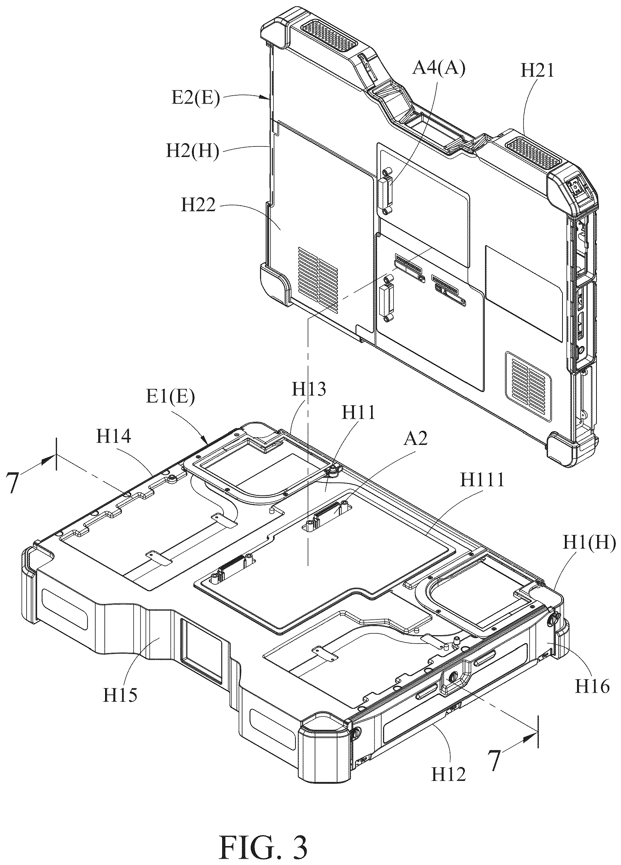

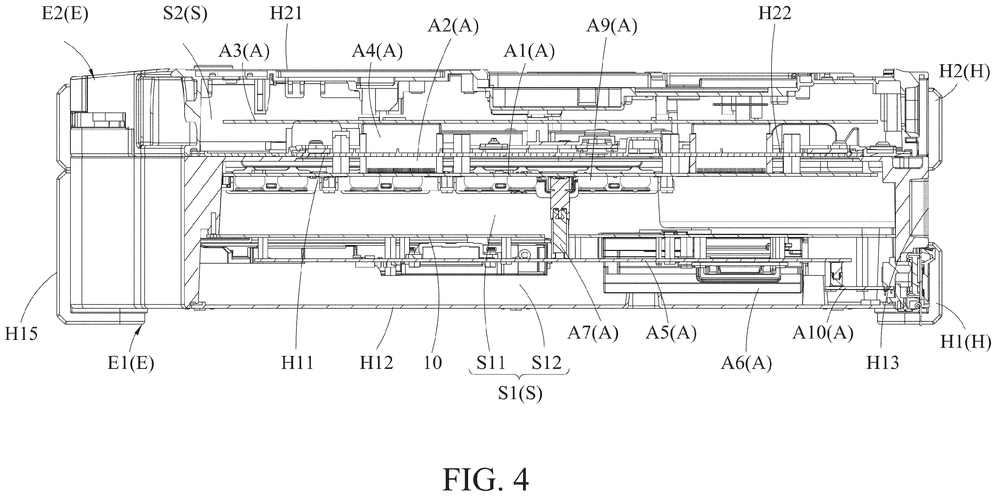

Referring to FIG. 1 to FIG. 4, FIG. 1 is a schematic three-dimensional external view of an embodiment of an electronic device assembly according to the present invention; FIG. 2 is a first schematic three-dimensional exploded diagram of an embodiment of an electronic device assembly according to the present invention; FIG. 3 is a second schematic three-dimensional exploded diagram of an embodiment of an electronic device assembly according to the present invention; and FIG. 4 is a schematic cross-sectional view drawn along a division line 4-4 in FIG. 1.

The present invention provides an electronic device assembly, including a plurality of overlapping electronic devices E. The electronic devices E include cases H and electronic components A, each of the cases H has an accommodating space S, the electronic components A are assembled in the accommodating space S of each of the cases H, and the electronic components A in adjacent cases H are assembled in an overlapping manner in the two cases H and can be electrically connected to each other. Therefore, the electronic device assembly may use the accommodating spaces S of the plurality of electronic devices E without external wiring to increase a quantity and types of assembled electronic components A, thereby satisfying diversified electronic function expansion.

Referring to FIG. 4, in the electronic device assembly, the cases H and different electronic components A arranged inside the cases may be matched and combined into electronic devices E with different function orientations. The electronic components A may be circuit boards, connectors, storage elements, or power supply elements with different function orientations.

Referring to FIG. 1, in some embodiments, the electronic device assembly includes two electronic devices E, where each of the electronic devices E includes a case H. An example in which the two electronic devices E are respectively an expansion component E1 and a host E2 is used below for description, but the present invention is not limited thereto.

Referring to FIG. 4, for clear description, in some embodiments in which the electronic device assembly includes the two electronic devices E, the cases H include a first case H1 and a second case H2, where the first case H1 includes a first accommodating space S1, the second case H2 includes a second accommodating space S2, the first case H1 is a part of the expansion component E1, and the second case H2 is a part of the host E2.

Referring to FIG. 4, the electronic device assembly includes the expansion component E1 and the host E2. The expansion component E1 includes the first accommodating space S1, the host E2 includes the second accommodating space S2, and different electronic components A are respectively arranged in the first accommodating space S1 and the second accommodating space S2. When the host E2 is assembled to the expansion component E1, one surface of the expansion component E1 abuts against and is electrically connected to one surface of the host E2, to increase spaces of the electronic device assembly for assembling the electronic components A and functions that can be provided by the electronic device assembly.

Referring to FIG. 3 and FIG. 4, in some embodiments, the electronic components A include a first circuit board A1 and a first connector A2 arranged in the first accommodating space S1 of the expansion component E1 and a main circuit board A3 and a main connector A4 arranged in the second accommodating space S2 of the host E2. In the embodiments, the main circuit board A3 may be a main board, and the first circuit board A1 is various expansion circuit boards that can cooperate with the main board, but the present invention is not limited thereto.

Referring to FIG. 3 and FIG. 4, in the embodiments, the expansion component E1 includes the first case H1, the first circuit board A1, and at least one first connector A2. The first case H1 includes a top plate H11 and a bottom plate H12 that are opposite to each other, where the first accommodating space S1 is formed between the top plate H11 and the bottom plate H12, and the top plate H11 is provided with an opening H111. The first circuit board A1 is arranged in the first accommodating space S1. The first connector A2 is electrically connected to the first circuit board A1, and the first connector A2 is exposed from the top plate H11 at the opening H111. It should be noted that as shown in FIG. 3, the opening H111 is further equipped with a plate that corresponds to a contour shape of the opening H111, and a through hole for the first connector A2 to pass through is provided on the plate, to prevent external water vapor or dust from entering the first case H1 at the opening H111. However, the opening H111 may not be provided with the plate, so that different electronic components A in the first case H1 pass through the opening H111. The present invention is not limited thereto.

Referring to FIG. 3 and FIG. 4, the host E2 includes the second case H2, the main circuit board A3, and at least one main connector A4. The second case H2 includes a first surface H21 and a second surface H22 that are opposite to each other, where the second accommodating space S2 is formed between the first surface H21 and the second surface H22. The main circuit board A3 is arranged in the second accommodating space S2. The main connector A4 is electrically connected to the main circuit board A3 and exposed from the second surface H22. When the host E2 is assembled to the expansion component E1, the second surface H22 of the second case H2 covers the top plate H11 of the first case H1 and the opening H111, and the first connector A2 is electrically connected to the main connector A4.

Therefore, the main circuit board A3 of the host E2 is electrically connected to the first connector A2 of the expansion component E1 by the main connector A4, so that the host E2 can be electrically connected to the first circuit board A1 inside the expansion component E1, to provide function expansion, and the first accommodating space S1 and the second accommodating space S2 are used together to increase the quantity and the types of assembled electronic components A, thereby providing more diversified functions and satisfying more diverse usage demands.

Referring to FIG. 1 to FIG. 4, in some embodiments, the case H (that is, the first case H1) of the expansion component E1 and the case H (that is, the second case H2) of the host E2 are six-sided cubic structures with corresponding appearance shapes. In the embodiments, the first case H1 further includes a first side edge H13, a second side edge H14, a third side edge H15, and a fourth side edge H16 that are sequentially connected, where the first side edge H13, the second side edge H14, the third side edge H15, and the fourth side edge H16 are respectively connected to the top plate H11 and the bottom plate H12 to form the first accommodating space S1. In the embodiments, a shape and a size of the second surface H22 of the case H (the second case H2) of the host E2 correspond to shapes and sizes of the top plate H11 and the bottom plate H12 of the first case H1, so that after the expansion component E1 and the host E2 are assembled, the expansion component and the host have flush outer contours and have an integrated appearance. In addition, a position of the first connector A2 on the top plate H11 corresponds to a position of the main connector A4 on the second surface H22. In this way, when the expansion component E1 and the host E2 are assembled in an overlapping manner, the first connector A2 can be electrically connected to the main connector A4, to achieve expansion.

Referring to FIG. 4, in some embodiments, the expansion component E1 further includes a partition 10, where the partition 10 is parallel to the top plate H11 and the bottom plate H12 and is arranged in the first accommodating space S1. In this way, the partition 10 is located between the top plate H11 and the bottom plate H12 and can divide the first accommodating space S1 into an upper compartment S11 and a lower compartment S12. Therefore, electronic components A with different function orientations may be respectively arranged in the upper compartment S11 and the lower compartment S12, to provide more diversified functional expansion.

In some embodiments, the first circuit board A1 is accommodated in the upper compartment S11 and assembled on a side of the top plate H11 toward the bottom plate H12. Therefore, the first circuit board A1 is arranged close to the top plate H11, to reduce an occupied space in the upper compartment S11 and improve utilization of the space in the upper compartment S11.

Referring to FIG. 4, in some embodiments, the electronic components A further include a second circuit board A5, a plurality of batteries A6, and a second connector A7. In the embodiments, the first circuit board A1 is arranged in the upper compartment S11 of the expansion component E1, the second circuit board A5 and the batteries A6 are arranged in the lower compartment S12 and are electrically connected to each other, and the second connector A7 penetrates the partition 10 and is electrically connected to the first circuit board A1 and the second circuit board A5. Therefore, the main circuit board A3, the first circuit board A1, and the second circuit board A5 may be configured in the electronic device assembly, to provide diversified functional expansion. In addition, the main circuit board A3 is electrically connected to the first circuit board A1, and the first circuit board A1 is electrically connected to the second circuit board A5 and the batteries A6, so that the batteries A6 arranged in the first accommodating space S1 can simultaneously supply power to the electronic components A in the first accommodating space S1 and the second accommodating space S2 without assembling the battery A6 in the second accommodating space S2, to improve a degree of freedom in space utilization of the second accommodating space S2. It should be noted that the first circuit board A1 and the second circuit board A5 may be replaced with circuit boards with different function orientations according to usage requirements, for example, bus circuit boards, display cards, network cards, or redundant array of independent disks (RAID) cards, but the present invention is not limited thereto.

Referring to FIG. 2, in some embodiments, the expansion component E1 further includes a waterproof member 20, where the waterproof member 20 is arranged around the opening H111. Therefore, it is ensured that the external water vapor cannot enter the first accommodating space S1 from the opening H111 of the expansion component E1, to ensure waterproofness of the expansion component E1.

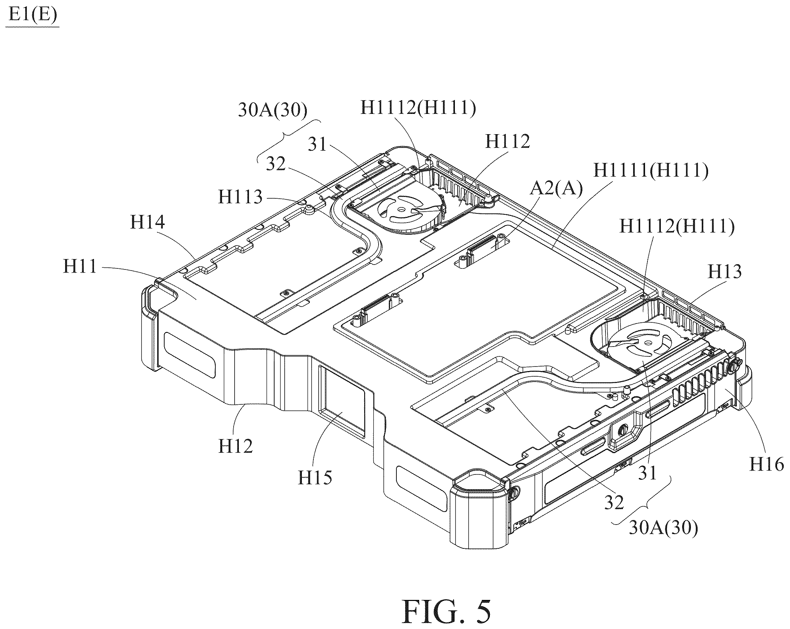

Referring to FIG. 5, in some embodiments, there are a plurality of openings H111 of the first case H1. In the embodiments, the openings H111 include a first opening H1111 and a second opening H1112, where the first opening H1111 is located in the middle of the top plate H11. Therefore, the middle of the top plate H11 is not limited to a centroid position of the top plate H11, and the middle of the top plate H11 means that an outer contour of the first opening H1111 does not abut against any one of the first side edge H13, the second side edge H14, the third side edge H15, and the fourth side edge H16. In the embodiments, the first connector A2 is exposed from the first opening H1111.

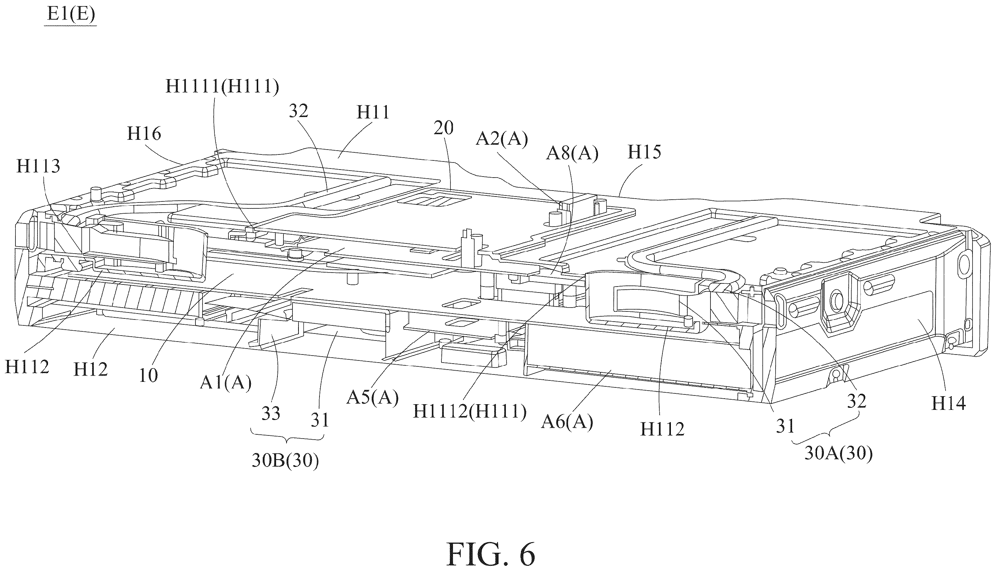

Referring to FIG. 5 and FIG. 6, the expansion component E1 of the electronic device assembly further includes a heat dissipation module 30, to dissipate heat for the electronic components A in the expansion component. In some embodiments, the heat dissipation module 30 includes a first heat dissipation module 30A and a second heat dissipation module 30B, where the first heat dissipation module 30A is arranged close to the top plate H11 (as shown in FIG. 5), and the second heat dissipation module 30B is arranged close to the bottom plate H12 (as shown in FIG. 6). Therefore, heat dissipation is fully performed inside the expansion component E1 through the heat dissipation module 30. It should be noted that the first heat dissipation module 30A or the second heat dissipation module 30B may be separately arranged in the expansion component E1, or the first heat dissipation module 30A and the second heat dissipation module 30B may be simultaneously arranged. The present invention is not limited thereto.

Referring to FIG. 5, in some embodiments, the first heat dissipation module 30A includes a fan 31 and a heat dissipation pipe 32, the top plate H11 of the first case H1 further includes an assembly groove H112, and the second opening H1112 is adjacent to any two adjacent side edges of the first side edge H13, the second side edge H14, the third side edge H15, and the fourth side edge H16. Referring to FIG. 5, the second opening H1112 is adjacent to the first side edge H13 and the second side edge H14, and the assembly groove H112 is located at a position corresponding to the second opening H1112 and is recessed from the top plate H11 to the bottom plate H12.

Referring to FIG. 5 and FIG. 6, in the embodiments, the fan 31 of the first heat dissipation module 30A is assembled in the assembly groove H112, one end of the heat dissipation pipe 32 corresponds to a position of the fan 31, and an other end of the heat dissipation pipe extends to the top plate H11 and corresponds to positions of the electronic components A inside the expansion component E1. Therefore, the heat dissipation pipe 32 can absorb heat generated by the electronic components A inside the expansion component E1 and conduct the heat to the position corresponding to the fan 31 for heat dissipation.

Referring to FIG. 5 and FIG. 6, in some embodiments, the top plate H11 of the expansion component E1 further includes a heat dissipation pipe groove H113, where the heat dissipation pipe groove H113 is recessed from the top plate H11 to the bottom plate H12, one end of the heat dissipation pipe groove H113 is engaged with the second opening H1112, and an other end of the heat dissipation pipe groove extends to the positions of the electronic components A in the expansion component E1. Therefore, even if the top plate H11 of the expansion component E1 is equipped with the heat dissipation pipe 32, because the heat dissipation pipe 32 is accommodated in the heat dissipation pipe groove H113, surface flatness can still be maintained, thereby ensuring that the host E2 can be smoothly assembled to the expansion component E1.

Referring to FIG. 4 and FIG. 6, in some embodiments, the electronic components A of the electronic device assembly further include disk arrays A8. In the embodiments, the disk arrays A8 are accommodated in the upper compartment S11 of the expansion component E1 and is electrically connected to the first circuit board A1, and the disk arrays A8 are located between the assembly groove H112 and the third side edge H15. Herein, the heat dissipation pipe 32 extends between the assembly groove H112 and the third side edge H15 to correspond to a position of the disk array A8, so as to fully dissipate heat for the disk array A8.

Referring to FIG. 4 and FIG. 6, in some embodiments, there are two disk arrays A8. In the embodiments, a quantity of second openings H1112 of the top plate H11 and a quantity of first heat dissipation modules 30A are equal to a quantity of disk arrays A8. In the embodiments, the two disk arrays A8 are respectively assembled on two sides of the first circuit board A1 (where one group of disk arrays A8 is displayed in FIG. 4), one second opening H1112 is adjacent to the first side edge H13 and the second side edge H14, the other second opening H1112 is adjacent to the first side edge H13 and the fourth side edge H16, and a heat dissipation pipe 32 of each first heat dissipation module 30A extends between the third side edge H15 and the two second openings H1112. Therefore, the first heat dissipation modules 30A can dissipate heat for the two disk arrays A8 accommodated in the upper compartment S11.

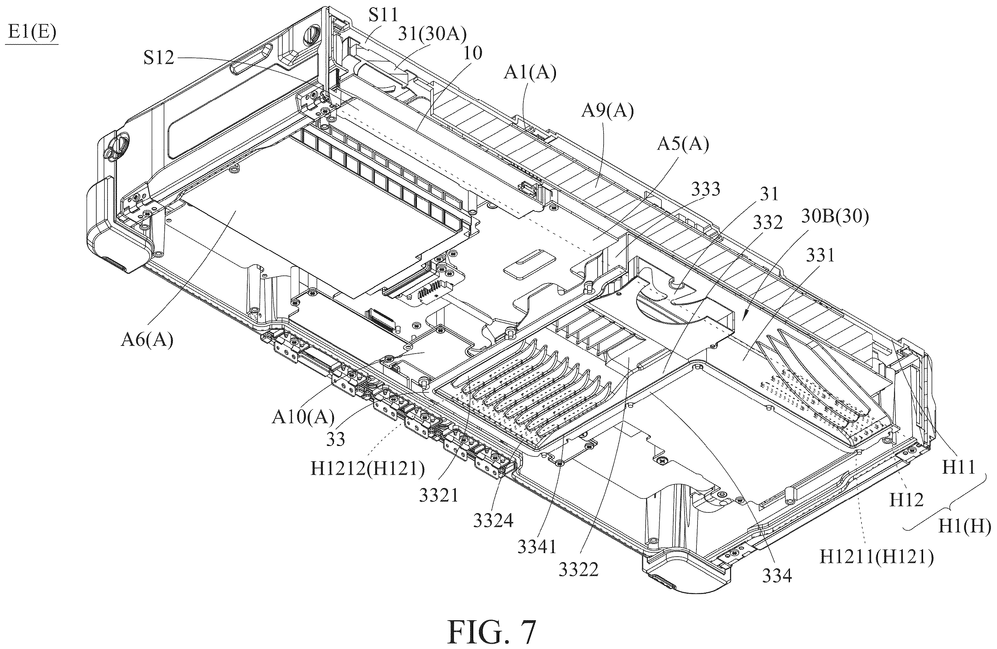

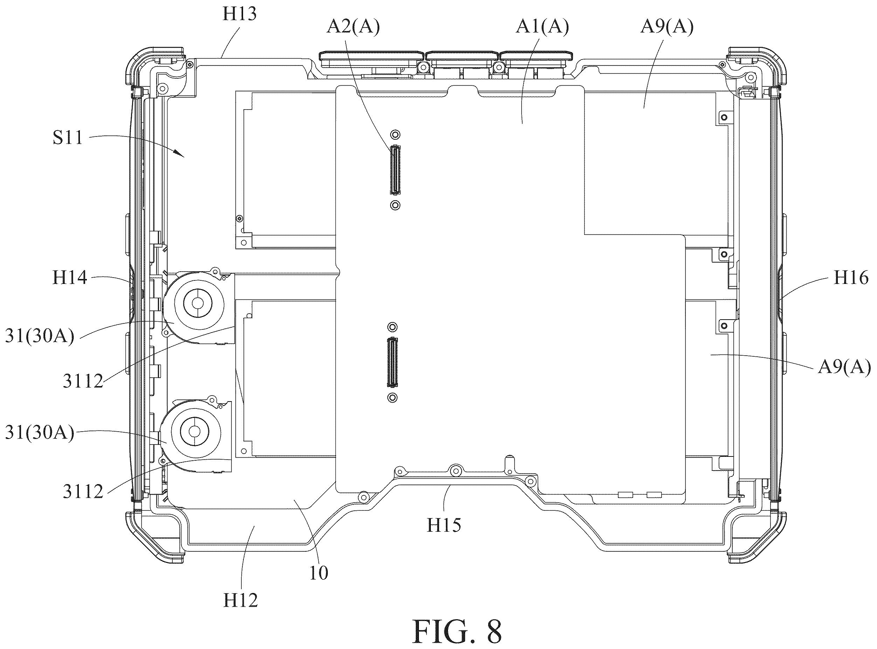

Referring to FIG. 7 and FIG. 8, FIG. 7 is a schematic cross-sectional view drawn along a division line 7-7 in FIG. 3. FIG. 8 is a schematic diagram of a partial structure of an embodiment of an expansion component according to the present invention. FIG. 8 is a schematic diagram in which configurations inside an upper compartment S11 are exposed without displaying a top plate H11 in a first case H1. In the embodiments, the electronic component A accommodated in the upper compartment S11 in the electronic device assembly and electrically connected to the first circuit board A1 is a bus apparatus A9 (for example, a PCI-E card, a PCI-E interface display card, a PCI-E interface SSD, or another PCI-E interface high-speed signal transmission apparatus). In the embodiments, the first heat dissipation module 30A includes the fan 31 that is accommodated in the upper compartment S11. Herein, the fan 31 is electrically connected to the first circuit board A1, the fan 31 is provided with an air outlet 3112, and the air outlet 3112 of the fan 31 faces toward the bus apparatus A9 to dissipate heat for the bus apparatus A9.

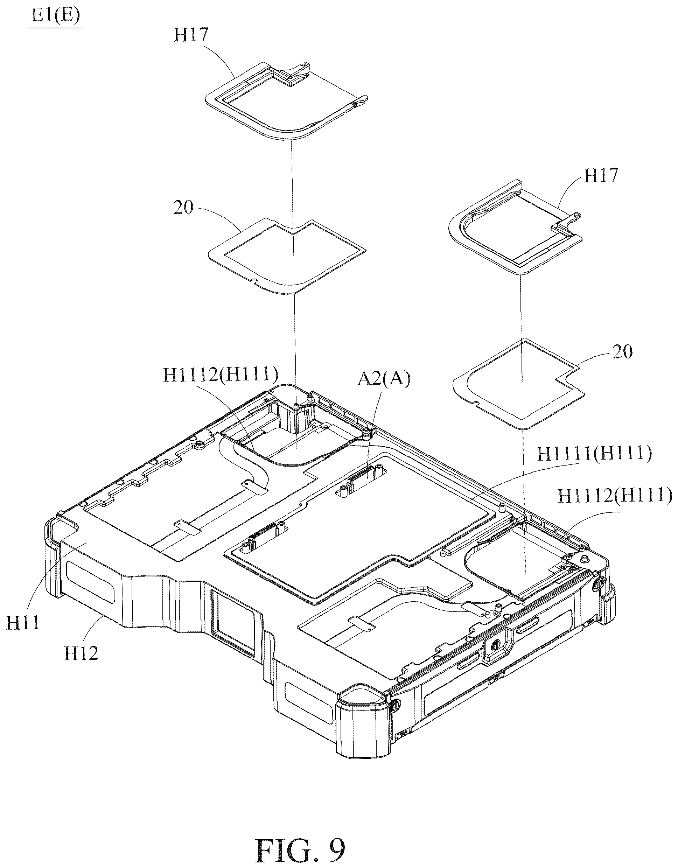

Referring to FIG. 8 and FIG. 9, in some embodiments in which the first heat dissipation module 30A is accommodated in the upper compartment S11 rather than arranged at the second opening H1112, the first case H1 does not include the assembly groove H112. In the embodiments, the first case H1 further includes a waterproof cover plate H17, where a shape and a size of the waterproof cover plate H17 corresponds to the shape and the size of the second opening H1112, and the waterproof cover plate H17 covers the second opening H1112, to close the second opening H1112, thereby ensuring waterproofness inside the first case H1.

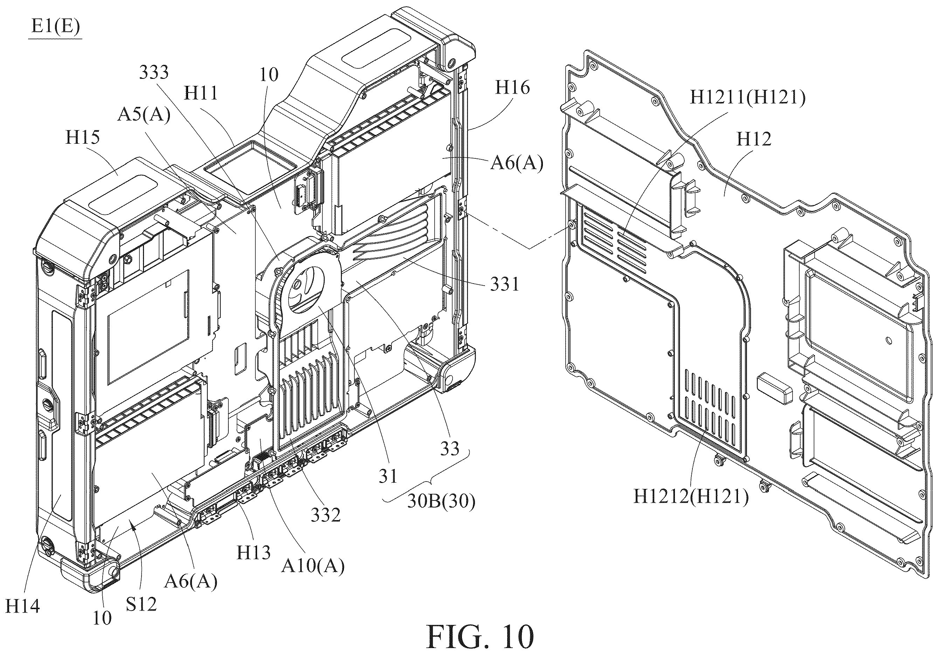

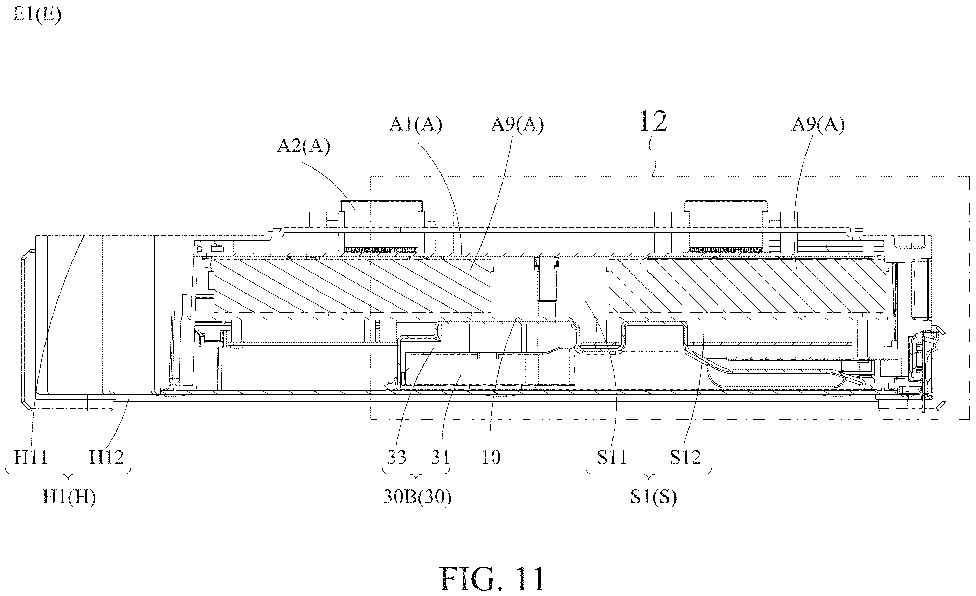

Referring to FIG. 10 to FIG. 12, in some embodiments, the second heat dissipation module 30B is arranged in the lower compartment S12 and can simultaneously dissipate heat for the electronic components A inside the upper compartment S11 and the lower compartment S12. In the embodiments, the electronic components A accommodated in the upper compartment S11 abut against the partition 10.

Referring to FIG. 10 to FIG. 12, the second heat dissipation module 30B includes the fan 31 and a diversion case 33. The diversion case 33 includes an input section 331 and an output section 332 that are connected. An angle is defined between an extending direction of the input section 331 and an extending direction of the output section 332, the diversion case 33 is accommodated in the lower compartment S12, and the output section 332 abuts against the partition 10 and one of the electronic components A located in the lower compartment S12. The fan 31 is arranged at a junction of the input section 331 and the output section 332.

Therefore, when the fan 31 of the second heat dissipation module 30B runs, an airflow is led into the input section 331 of the diversion case 33 and then is led out from the output section 332, heat generated by the partition 10 and the electronic component A located in the lower compartment S12 against which the output section 332 abut can be conducted outside the expansion component E1 through the airflow, and heat dissipation can be simultaneously performed on the electronic components A accommodated in the upper compartment S11 and the lower compartment S12 by using the second heat dissipation module 30B, to reduce a space occupied by assembling the heat dissipation structure or the internal diversion device, and improve utilization of the internal space of the electronic device assembly.

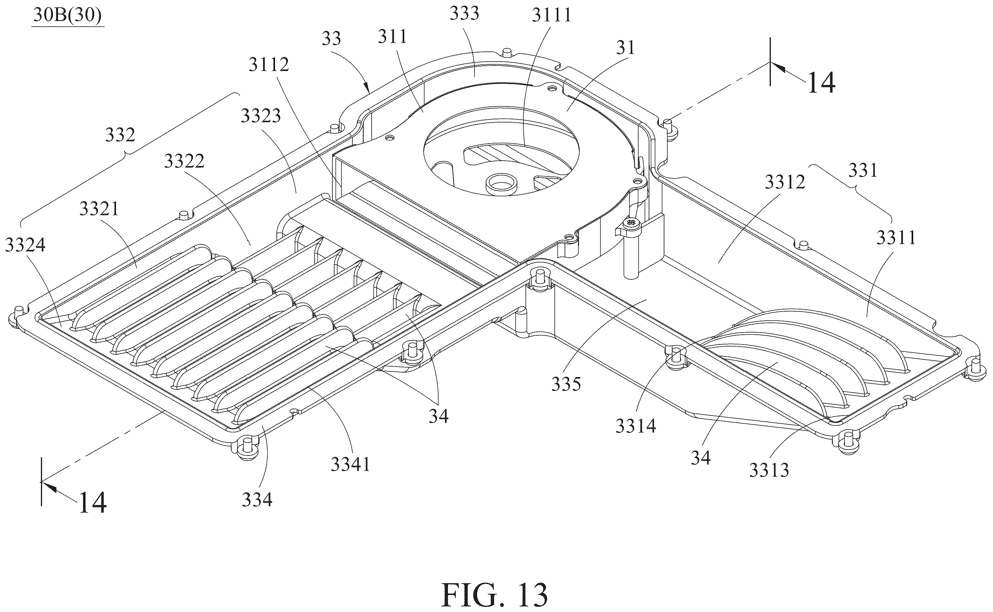

Referring to FIG. 10 and FIG. 13, in some embodiments, the input section 331 and the output section 332 of the diversion case 33 are connected to form an L-shape. That is, the angle between the extending direction of the input section 331 and the extending direction of the output section 332 is 90 degrees. Therefore, a position at which the second heat dissipation module 30B introduces the airflow and a position at which the airflow is led out for heat dissipation are not on a same straight line but can meet position configuration requirements of different electronic components A inside the lower compartment S12.

Referring to FIG. 10 and FIG. 13, in some embodiments, the diversion case 33 includes a connecting section 333, where the connecting section 333 is located between the input section 331 and the output section 332, and the fan 31 is accommodated in the connecting section 333. In the embodiments, an end of the input section 331 away from the connecting section 333 and an end of the output section 332 away from the connecting section are respectively inclined relative to the connecting section 333. Therefore, depths may be configured for a part between the connecting section 333 and the input section 331 and a part between the output section 332 and the connecting section 333 for collecting and guiding an airflow, and the end of the input section 331 away from the connecting section 333 and the end of the output section 332 away from the connecting section may be close to an assembled position of the diversion case 33, to smoothly guide input and output of the airflow.

Referring to FIG. 10 and FIG. 13, in some embodiments, the entire diversion case 33 includes an edge 334, where the edge 334 surrounds and forms an opening 3341, and the input section 331, the output section 332, and the connecting section 333 are located within a range of the opening 3341. In the embodiments, the bottom plate H12 of the first case H1 of the expansion component E1 includes a plurality of through holes H121. The edge 334 of the diversion case 33 abuts against the bottom plate H12 of the first case H1, and the opening 3341 covers the through hole H121. Therefore, the airflow can be smoothly inputted into the diversion case 33 from the bottom plate H12 of the first case H1 and outputted from the diversion case 33, to ensure a diversion effect and a heat dissipation effect of the diversion case 33.

Referring to FIG. 7 and FIG. 10, in some embodiments, the through holes H121 of the bottom plate H12 of the first case H1 include a plurality of first through holes H1211 and a plurality of second through holes H1212. Positions of the first through holes H1211 correspond to a position of the input section 331, and positions of the second through holes H1212 correspond to a position of the output section 332, to ensure smoothness of the airflow flowing in and out of the diversion case 33.

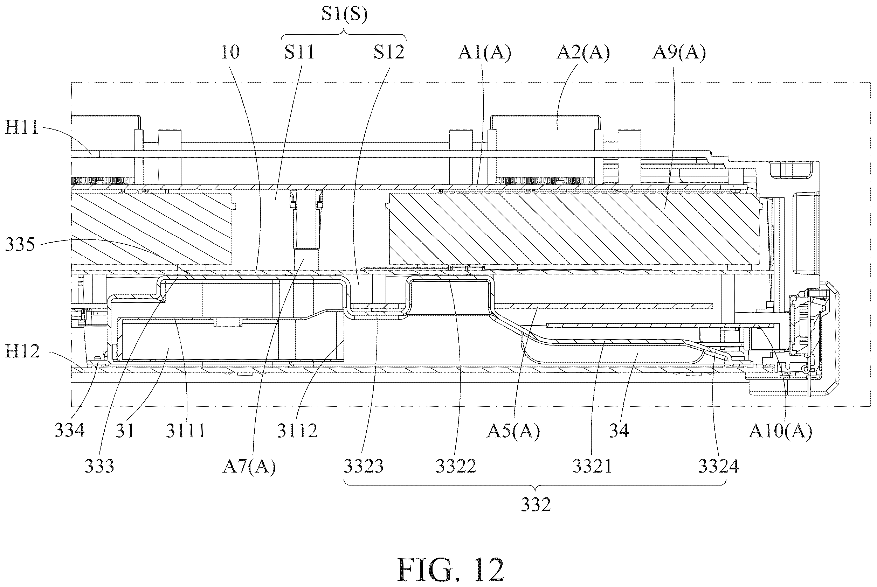

Referring to FIG. 12 to FIG. 14, in some embodiments, the diversion case 33 includes an inner surface 335. When the diversion case 33 is assembled on the bottom plate H12 of the first case H1, the inner surface 335 faces toward the bottom plate H12, and the inner surface 335 has different depth configurations to be attached to different electronic components A, so as to dissipate heat for a plurality of electronic components A simultaneously. In the embodiments, the output section 332 includes a first heat dissipation section 3321 and a second heat dissipation section 3322. The inner surface 335 has a first height L1 between the first heat dissipation section 3321 and the opening 3341, the inner surface 335 has a second height L2 between the second heat dissipation section 3322 and the opening 3341, and the first height L1 is different from the second height L2. Therefore, the diversion case 33 may be simultaneously in contact with the electronic components A located inside the lower compartment S12 and the upper compartment S11 through the first heat dissipation section 3321 and the second heat dissipation section 3322 and can simultaneously dissipate heat for the electronic components A located inside the upper compartment S11 and the lower compartment S12.

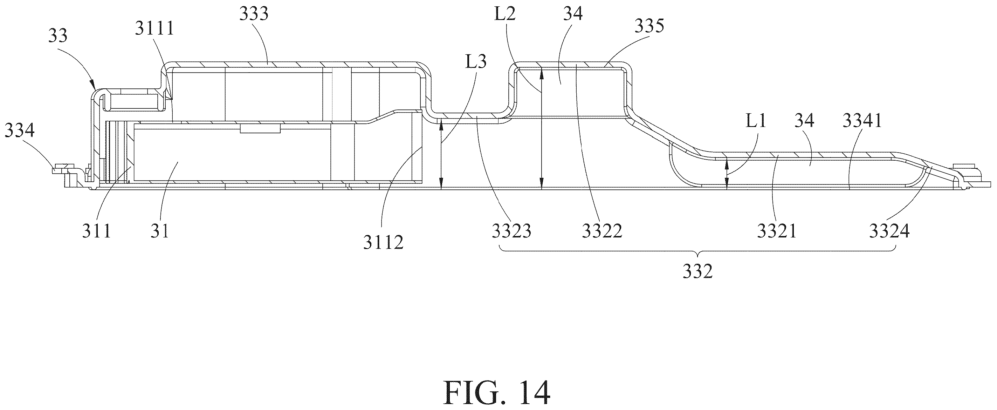

Referring to FIG. 12 and FIG. 14, in the embodiments, the first height L1 is less than the second height L2, that is, a distance of the inner surface 335 between the first heat dissipation section 3321 and the opening 3341 is less than a distance of the inner surface 335 between the second heat dissipation section 3322 and the opening 3341, and the first heat dissipation section 3321 is closer to the bottom plate H12 than the second heat dissipation section 3322. Therefore, the first heat dissipation section 3321 of the diversion case 33 abuts against the electronic component A located in the lower compartment S12, the second heat dissipation section 3322 abuts against the partition 10, and a position of the second heat dissipation section 3322 corresponds to the position of the electronic component A located in the upper compartment S11.

Referring to FIG. 12, in the embodiments in which the electronic component A located in the upper compartment S11 is the bus apparatus A9, the bus apparatus A9 abuts against the partition 10, and the second heat dissipation section 3322 of the diversion case 33 abuts against a position at which the partition 10 corresponds to the bus apparatus A9 to dissipate heat for the bus apparatus A9. In the embodiments, the electronic components A of the expansion component E1 further include a third circuit board A10, where the third circuit board A10 is arranged in the lower compartment S12 and is parallel to and spaced apart from the second circuit board A5, and the third circuit board A10 is closer to the bottom plate H12 than the second circuit board A5. Herein, the first heat dissipation section 3321 of the diversion case 33 abuts against the third circuit board A10 to dissipate heat for the third circuit board A10. Therefore, a plurality of overlapping electronic components A may be configured in the lower compartment S12 of the expansion component E1, and heat of the overlapping electronic components A can still be fully dissipated by the second heat dissipation module 30B, to ensure that the electronic components A can smoothly run, thereby ensuring an expansion function of the expansion component E1.

Referring to FIG. 12 to FIG. 14, in some embodiments, the output section 332 of the diversion case 33 further includes a third heat dissipation section 3323, where the first heat dissipation section 3321, the second heat dissipation section 3322, and the third heat dissipation section 3323 of the output section 332 are sequentially connected, and the third heat dissipation section 3323 of the output section 332 is connected to the fan 31. Therefore, air enters from the input section 331 of the diversion case 33, then enters the fan 31, and then is discharged sequentially by the third heat dissipation section 3323, the second heat dissipation section 3322, and the first heat dissipation section 3321 of the output section 332. In this way, the heat of all the electronic components A abutting against the first heat dissipation section 3321, the second heat dissipation section 3322, and the third heat dissipation section 3323 can be dissipated by the diversion case 33.

Referring to FIG. 12 to FIG. 14, in some embodiments, the inner surface 335 of the diversion case 33 has a third height L3 between the third heat dissipation section 3323 and the opening 3341, where the third height L3 is different from the first height L1 and the second height L2. Therefore, the electronic components A against which the first heat dissipation section 3321, the second heat dissipation section 3322, and the third heat dissipation section 3323 abut for heat dissipation may be respectively located at different height positions but can still be fully dissipated by the diversion case 33. In the embodiments, the third heat dissipation section 3323 abuts against the second circuit board A5, but the present invention is not limited thereto.

Referring to FIG. 12 to FIG. 14, in some embodiments, the fan 31 is a centrifugal fan and includes a case 311, where the case 311 is provided with an air inlet 3111 and an air outlet 3112 that are perpendicular to each other. The third heat dissipation section 3323 of the output section 332 of the diversion case 33 is flush with the air outlet 3112 of the fan 31. Therefore, an airflow outputted from the air outlet 3112 of the fan 31 can smoothly enter the output section 332 from the third heat dissipation section 3323, to improve smoothness of the airflow.

Referring to FIG. 12 to FIG. 14, in the embodiments in which the third heat dissipation section 3323 of the diversion case 33 is flush with the fan 31, the third height L3 is greater than the first height L1 and is less than the second height L2. Therefore, a large amount of air entering the output section 332 from the fan 31 can be collected at the second heat dissipation section 3322 after passing through the third heat dissipation section 3323, to obviously dissipate heat for the electronic component A at a position corresponding to the partition 10, and then is discharged by the first heat dissipation section 3321 closest to the bottom plate H12.

Referring to FIG. 12 to FIG. 14, in some embodiments, the input section 331 of the diversion case 33 includes an inlet section 3311 and a collecting section 3312 that are sequentially connected, where the collecting section 3312 is connected between the inlet section 3311 and the connecting section 333 and is flush with the connecting section 333. In the embodiments, the fan 31 is arranged in the connecting section 333 and the air inlet 3111 faces toward the inner surface 335, and a distance is provided between the air inlet 3111 of the fan 31 and the inner surface 335. Therefore, air can enter the fan 31 after being guided by the input section 331 of the diversion case 33 for the fan 31 to generate an active airflow.

Referring to FIG. 12 to FIG. 14, in some embodiments, the inner surface 335 of the diversion case 33 also has the second height L2 from the opening 3341 at the position of the collecting section 3312 and the connecting section 333. Therefore, the collecting section 3312 can collect a large amount of air introduced by the inlet section 3311 into the fan 31, so as to improve a flow rate of air flowing through the diversion case 33 and the heat dissipation efficiency. In addition, because the connecting section 333 also has the second height L2, when the diversion case 33 is assembled in the lower compartment S12, the connecting section 333 can also abut against the partition 10, to increase an area where the partition 10 abuts against the diversion case 33, thereby improving a support force of the partition 10 and also improving heat dissipation effect for the electronic components A abutting against the partition 10.

Referring to FIG. 12 to FIG. 14, in some embodiments, the second heat dissipation module 30B further includes a plurality of heat dissipation fins 34, where the heat dissipation fins 34 are arranged in the diversion case 33. In the embodiments, the plurality of heat dissipation fins 34 are respectively arranged in the first heat dissipation section 3321, the second heat dissipation section 3322, and the inlet section 3311 of the diversion case 33, and the heat dissipation fins 34 in the first heat dissipation section 3321, the second heat dissipation section 3322, and the inlet section 3311 are parallel to and spaced apart from each other. Therefore, a contact area between the air and the diversion case 33 is increased, to improve the heat dissipation effect.

Referring to FIG. 12 to FIG. 14, in some embodiments, the inlet section 3311 of the input section 331 of the diversion case 33 has a first end 3313 and a second end 3314, where the second end 3314 is closer to the fan 31 than the first end 3313 and is connected to the fan 31, a height of the inner surface 335 from the second end 3314 to the opening 3341 is greater than a height of the inner surface from the first end 3313 to the opening 3341, and the first end 3313 is obliquely connected to the second end 3314, so that the inlet section 3311 is inclined to the bottom plate H12. In this way, the inlet section 3311 obliquely extends to the bottom plate H12, and air is introduced by the first through hole H1211 of the bottom plate H12, to improve the smoothness of the air entering the diversion case 33.

Referring to FIG. 12 to FIG. 14, in some embodiments, the output section 332 of the diversion case 33 further includes an outlet section 3324, where the outlet section 3324 is connected to the first heat dissipation section 3321 and is inclined to the first heat dissipation section 3321, so that the outlet section 3324 obliquely extends to the bottom plate H12. In this way, the outlet section 3324 obliquely extends to the bottom plate H12, and air is introduced by the second through hole H1212 of the bottom plate H12, to improve the smoothness of the air entering the diversion case 33.

Referring to FIG. 12 to FIG. 14, in some embodiments, the inner surface 335 of the diversion case 33 is inclined relative to the bottom plate H12 in an extending direction between the first heat dissipation section 3321 and the second heat dissipation section 3322. Therefore, it is ensured that the air in the second heat dissipation section 3322 farthest from the opening 3341 can smoothly flow to the first heat dissipation section 3321, to ensure the smoothness of the heat dissipation airflow.

Further aspects of the invention:
According to a first further aspect of the present invention, an electronic device assembly is provided, said electronic device assembly comprising:
an expansion component (E1), comprising:
   a first case (H1), comprising a top plate (H11) and a bottom plate (H12) that are opposite to each other, wherein a first accommodating space (S1) is formed between the top plate (H11) and the bottom plate (H12), and the top plate (H11) is provided with an opening (H111);
   a first circuit board (A1), arranged in the first accommodating space (S1); and
   at least one first connector (A2), electrically connected to the first circuit board (A1), wherein the at least one first connector (A2) is exposed from the top plate (H11) at the opening (H111); and
a host (E2), comprising:
   a second case (H2), comprising a first surface (H21) and a second surface (H22) that are opposite to each other, wherein a second accommodating space (S2) is formed between the first surface (H21) and the second surface (H22);
   a main circuit board (A3), arranged in the second accommodating space (S2); and
   at least one main connector (A4), electrically connected to the main circuit board (A3) and exposed from the second surface (H22), wherein when the host (E2) is assembled to the expansion component (E1), the second surface (H22) of the second case (H2) covers the top plate (H11) of the first case (H1) and the opening (H111), and the at least one first connector (A2) is electrically connected to the at least one main connector (A4).

According to a second further aspect, the electronic device assembly according to the first further aspect is provided, wherein the opening (H111) is located in the middle of the expansion component (E1), and the expansion component (E1) further comprises a waterproof member (20) that is arranged around the opening (H111).

According to a third further aspect, the electronic device assembly according to the first further aspect is provided, wherein the expansion component (E1) further comprises a partition (10), wherein the partition (10) is parallel to the top plate (H11) and is arranged in the first accommodating space (S1), and divides the first accommodating space (S1) of the expansion component (E1) into an upper compartment (S11) and a lower compartment (S12).

According to a fourth further aspect, the electronic device assembly according to the third further aspect is provided, further comprising a second circuit board (A5), a plurality of batteries (A6), and a second connector (A7), wherein the first circuit board (A1) is arranged in the upper compartment (S11), the second circuit board (A5) and the plurality of batteries (A6) are arranged in the lower compartment (S12) and are electrically connected to each other, and the second connector (A7) penetrates the partition (10) and is electrically connected to the first circuit board (A1) and the second circuit board (A5).

According to a fifth further aspect, an expansion component (E1) is provided, said expansion component comprising:
a case (H), comprising a bottom plate (H12), a top plate (H11), and a first side edge (H13), a second side edge (H14), a third side edge (H15), and a fourth side edge (H16) that are sequentially connected, wherein the first side edge (H13), the second side edge (H14), the third side edge (H15), and the fourth side edge (H16) are respectively connected to the bottom plate (H12) and the top plate (H11) to form an accommodating space (S);
two openings (H111), running through the top plate (H11) and located on the first side edge (H13), wherein the two openings (H111) are respectively adjacent to the second side edge (H14) and the fourth side edge (H16);
a partition (10), arranged in the accommodating space (S) and parallel to the bottom plate (H12), wherein the partition (10) divides the accommodating space (S) into an upper compartment (S11) and a lower compartment (S12); and
a plurality of electronic components (A), arranged in the accommodating space (S) and scattered in the upper compartment (S11) and the lower compartment (S12).

According to a sixth further aspect, the expansion component (E1) according to the fifth further aspect is provided, further comprising two assembly grooves (H112), respectively corresponding to the two openings (H111), wherein the two assembly grooves (H112) are connected to the top plate (H11) and are recessed toward the bottom plate (H12).

According to a seventh further aspect, the expansion component (E1) according to the sixth further aspect is provided, further comprising two fans (31), respectively assembled in the two assembly grooves (H112).

According to an eighth further aspect, the expansion component (E1) according to the seventh further aspect is provided, wherein two heat dissipation pipe grooves (H113) are recessed on a side of the top plate (H11) away from the bottom plate (H12), and the two heat dissipation pipe grooves (H113) respectively extend from the third side edge (H15) to the two corresponding openings (H111).

According to a ninth further aspect, the expansion component (E1) according to the sixth further aspect is provided, wherein the electronic components (A) comprise:
a first circuit board (A1), accommodated in the upper compartment (S11) and assembled on a side of the top plate (H11) toward the bottom plate (H12);
a second circuit board (A5), accommodated in the lower compartment (S12); and
a second connector (A7), penetrating the partition (10) and electrically connected to the first circuit board (A1) and the second circuit board (A5).

According to a tenth further aspect, the expansion component (E1) according to the ninth further aspect is provided, wherein the electronic components (A) further comprise a plurality of disk arrays (A8), accommodated in the upper compartment (S11) and electrically connected to the first circuit board (A1), wherein the disk arrays (A8) are respectively assembled on two sides of the first circuit board (A1) and located between one assembly groove (H112) and the third side edge (H15).

According to an eleventh further aspect, the expansion component (E1) according to the tenth further aspect is provided, wherein two heat dissipation pipes (32) are arranged on a side of the top plate (H11) away from the bottom plate (H12), and the two heat dissipation pipes (32) correspond to the plurality of disk arrays (A8).

According to a twelfth further aspect, the expansion component (E1) according to the fifth further aspect is provided, further comprising two waterproof cover plates (H17), correspondingly covering the two openings (H111).

According to a thirteenth further aspect, the expansion component (E1) according to the twelfth further aspect is provided, wherein the electronic components (A) comprise:
a first circuit board (A1), accommodated in the upper compartment (S11) and assembled on a side of the top plate (H11) toward the bottom plate (H12);
two bus apparatuses (A9), accommodated in the upper compartment (S11) and electrically connected to the first circuit board (A1);
at least one fan (31), accommodated in the upper compartment (S11) and electrically connected to the first circuit board (A1);
a second circuit board (A5), accommodated in the lower compartment (S12); and
a second connector (A7), penetrating the partition (10) and electrically connected to the first circuit board (A1) and the second circuit board (A5).

According to a fourteenth further aspect, the expansion component (E1) according to the thirteenth further aspect is provided, wherein the electronic components (A) further comprise at least one battery (A6), assembled in the lower compartment (S12) and electrically connected to the second circuit board (A5).

According to a fifteenth further aspect, an expansion component (E1) is provided, comprising:
a case (H), comprising a bottom plate (H12), a top plate (H11), and a first side edge (H13), a second side edge (H14), a third side edge (H15), and a fourth side edge (H16) that are sequentially connected, wherein the first side edge (H13), the second side edge (H14), the third side edge (H15), and the fourth side edge (H16) are respectively connected to the bottom plate (H12) and the top plate (H11) to form an accommodating space (S);
two openings (H111), running through the top plate (H11) and located on the first side edge (H13), wherein the two openings (H111) are respectively adjacent to the second side edge (H14) and the fourth side edge (H16);
a partition (10), arranged in the accommodating space (S) and parallel to the bottom plate (H12), wherein the partition (10) divides the accommodating space (S) into an upper compartment (S11) and a lower compartment (S12);
a first circuit board (A1), accommodated in the upper compartment (S11);
a second circuit board (A5), accommodated in the lower compartment (S12);
at least one battery (A6), accommodated in the lower compartment (S12) and electrically connected to the second circuit board (A5); and
a second connector (A7), penetrating the partition (10) and electrically connected to the first circuit board (A1) and the second circuit board (A5).

It must be noted that the applicant reserves the right to claim the first, fifth and/or fifteenth further aspect as an independent claim, be it in the present application or a potential future divisional application.

## Claims

1. An expansion component (E1), comprising:
a case (H), comprising a bottom plate (H12), a top plate (H11), and a first side edge (H13), a second side edge (H14), a third side edge (H15), and a fourth side edge (H16) that are sequentially connected, wherein the first side edge (H13), the second side edge (H14), the third side edge (H15), and the fourth side edge (H16) are respectively connected to the bottom plate (H12) and the top plate (H11) to form an accommodating space (S);
two openings (H111), running through the top plate (H11) and located on the first side edge (H13), wherein the two openings (H111) are respectively adjacent to the second side edge (H14) and the fourth side edge (H16);
a partition (10), arranged in the accommodating space (S) and parallel to the bottom plate (H12), wherein the partition (10) divides the accommodating space (S) into an upper compartment (S11) and a lower compartment (S12); and
a plurality of electronic components (A), arranged in the accommodating space (S) and scattered in the upper compartment (S11) and the lower compartment (S12).

2. The expansion component (E1) according to claim 1, further comprising two assembly grooves (H112), respectively corresponding to the two openings (H111), wherein the two assembly grooves (H112) are connected to the top plate (H11) and are recessed toward the bottom plate (H12).

3. The expansion component (E1) according to claim 2, further comprising two fans (31), respectively assembled in the two assembly grooves (H112).

4. The expansion component (E1) according to claim 3, wherein two heat dissipation pipe grooves (H113) are recessed on a side of the top plate (H11) away from the bottom plate (H12), and the two heat dissipation pipe grooves (H113) respectively extend from the third side edge (H15) to the two corresponding openings (H111).

5. The expansion component (E1) according to claim 2, wherein the electronic components (A) comprise:
a first circuit board (A1), accommodated in the upper compartment (S11) and assembled on a side of the top plate (H11) toward the bottom plate (H12);
a second circuit board (A5), accommodated in the lower compartment (S12); and
a second connector (A7), penetrating the partition (10) and electrically connected to the first circuit board (A1) and the second circuit board (A5).

6. The expansion component (E1) according to claim 5, wherein the electronic components (A) further comprise a plurality of disk arrays (A8), accommodated in the upper compartment (S11) and electrically connected to the first circuit board (A1), wherein the disk arrays (A8) are respectively assembled on two sides of the first circuit board (A1) and located between one assembly groove (H112) and the third side edge (H15).

7. The expansion component (E1) according to claim 6, wherein two heat dissipation pipes (32) are arranged on a side of the top plate (H11) away from the bottom plate (H12), and the two heat dissipation pipes (32) correspond to the plurality of disk arrays (A8).

8. The expansion component (E1) according to claim 1, further comprising two waterproof cover plates (H17), correspondingly covering the two openings (H111).

9. The expansion component (E1) according to claim 8, wherein the electronic components (A) comprise:
a first circuit board (A1), accommodated in the upper compartment (S11) and assembled on a side of the top plate (H11) toward the bottom plate (H12);
two bus apparatuses (A9), accommodated in the upper compartment (S11) and electrically connected to the first circuit board (A1);
at least one fan (31), accommodated in the upper compartment (S11) and electrically connected to the first circuit board (A1);
a second circuit board (A5), accommodated in the lower compartment (S12); and
a second connector (A7), penetrating the partition (10) and electrically connected to the first circuit board (A1) and the second circuit board (A5).

10. The expansion component (E1) according to claim 9, wherein the electronic components (A) further comprise at least one battery (A6), assembled in the lower compartment (S12) and electrically connected to the second circuit board (A5).

11. The expansion component (E1) according to claim 1, wherein the plurality of electronic components (A) includes:
a first circuit board (A1), accommodated in the upper compartment (S11);
a second circuit board (A5), accommodated in the lower compartment (S12);
at least one battery (A6), accommodated in the lower compartment (S12) and electrically connected to the second circuit board (A5); and
a second connector (A7), penetrating the partition (10) and electrically connected to the first circuit board (A1) and the second circuit board (A5).
